**Europäisches Patentamt**

**European Patent Office**

**Office européen des brevets**

(11) Veröffentlichungsnummer: **0 199 149**
A2

## (12) EUROPÄISCHE PATENTANMELDUNG

(21) Anmeldenummer: **86104453.5**

(22) Anmeldetag: **02.04.86**

(51) Int. Cl.⁴: **H 05 K 13/00**

(30) Priorität: **18.04.85 DE 3514020**

(43) Veröffentlichungstag der Anmeldung:
**29.10.86 Patentblatt 86/44**

(84) Benannte Vertragsstaaten:
**FR GB IT**

(71) Anmelder: **TELEFUNKEN electronic GmbH**
**Theresienstrasse 2**
**D-7100 Heilbronn(DE)**

(72) Erfinder: **Günzel, Gerhard, Dipl.-Ing.**
**Alter Hochweg 9**
**D-7100 Heilbronn-Klingenberg(DE)**

(74) Vertreter: **Maute, Hans-Jürgen, Dipl.-Ing.**
**TELEFUNKEN electronic GmbH Theresienstrasse 2**
**D-7100 Heilbronn(DE)**

(54) **Elektrisches Bauelement.**

(57) Die Erfindung betrifft ein elektrisches Bauelement mit einem Keramikgehäuse, für das eine Verpackungsart vorgesehen ist, bei der mehrere Bauelemente mit ihren Keramikgehäusen stirnseitig aneinandergereiht sind. Durch Aufbringen einer elastisch verformbaren dünnen Schicht aus Polyimid auf Bereiche der Stirnseiten wird dafür gesorgt, daß keine Transportschäden durch Aneinanderstoßen der Keramikkörper an den Stirnseiten auftreten können.

FIG. 2

EP 0 199 149 A2

TELEFUNKEN electronic GmbH          **0199149**
Theresienstr. 2, 7100 Heilbronn

Heilbronn, 03.04.1985
T/E7-Se/ra - HN 83/42

## Elektrisches Bauelement

Die Erfindung betrifft ein elektrisches Bauelement mit einem Keramikgehäuse, für das eine Verpackungsart vorgesehen ist, bei der mehrere Bauelemente mit ihren Keramikgehäusen stirnseitig aneinandergereiht sind.

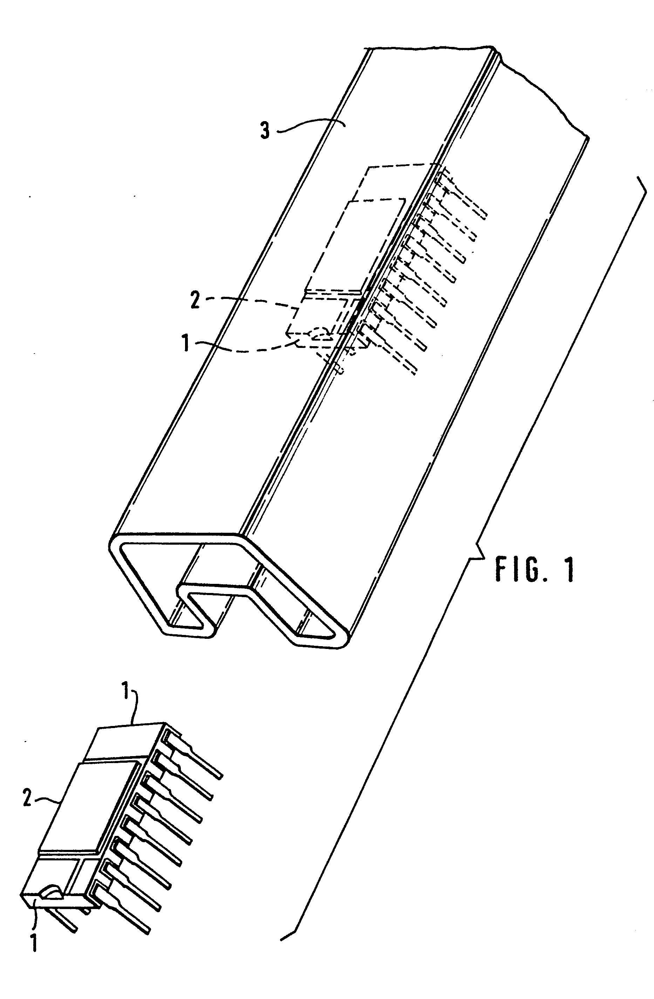

Unter einem elektrischen Bauelement mit einem Keramikgehäuse sind im allgemeinen Bauelemente mit einem Keramikkörper als Substrat zu verstehen, auf dem oder in dem sich das eigentliche Bauelement befindet. Beim Transport von Keramikgehäusen in Schienen gemäß der Figur 1 besteht die Gefahr, daß die Stirnseiten 1 der Gehäuse 2 gegeneinanderstoßen und dabei Risse in der Keramik entstehen, die zum Ausfall von Bauelementen führen. Dieser Effekt ist besonders kritisch bei - mit bloßem Auge nicht erkennbaren - Haarrissen, die bei Temperaturschwankungen weiterreißen und Wackelkontakte erzeugen.

Der Erfindung liegt die Aufgabe zugrunde, ein elektrisches Bauelement anzugeben, welches so ausgebildet ist, daß möglichst keine Transportschäden auftreten. Außerdem soll die Lösung möglichst einfach sein. Diese Aufgabe wird bei einem elektrischen Bauelement der eingangs erwähnten Art nach der Erfindung dadurch gelöst, daß mindestens eine Stirnseite des Keramikgehäuses mit einer Schicht ganzflächig oder teilweise versehen ist, die derart ausgebildet ist, daß sie Transportschäden am Keramikgehäuse, die durch stirnseitiges Aneinanderstoßen beim Transport entstehen können, vermeidet.

Die nach der Erfindung vorgesehene Schicht soll einerseits ausreichend dick und elastisch genug sein, um Stöße, die beim Transport in Schienen entstehen, abzufangen bzw. aufzufangen. Andererseits soll aber die stirnseitig vorgesehene Schicht vorzugsweise so dünn sein, daß sie die Anwendung von automatischen Greifersystemen nicht behindert. Die nach der Erfindung vorgesehene Schicht weist beispielsweise eine Dicke von 0,1 bis 0,3 mm auf.

Die nach der Erfindung vorgesehene Schicht an den Stirnseiten der Keramik soll eine gewisse Hitzebeständigkeit aufweisen, die von den jeweiligen Anforderungen abhängt. Erfolgt die Beschichtung beispielsweise vor der Chip- und Deckellötung, so ist eine Hitzebeständigkeit bis ca. 500 °C erforderlich. Erfolgt die Beschichtung dagegen am fertigen IC, so muß die Schicht bis ca. 300 °C hitzebeständig sein, und zwar wegen des Einlötens in eine Platine. Die nach der Erfindung vorgesehene Schicht besteht beispielsweise aus Polyimid.

Gemäß einer Weiterbildung der Erfindung werden nicht die gesamten Stirnseiten der Keramikgehäuse beschichtet, sondern nur ein Teil davon (in Gestalt von Flecken z. B.), und zwar beispielsweise nur die Ecken.

Die Erfindung wird im folgenden an einem Ausführungsbeispiel erläutert.

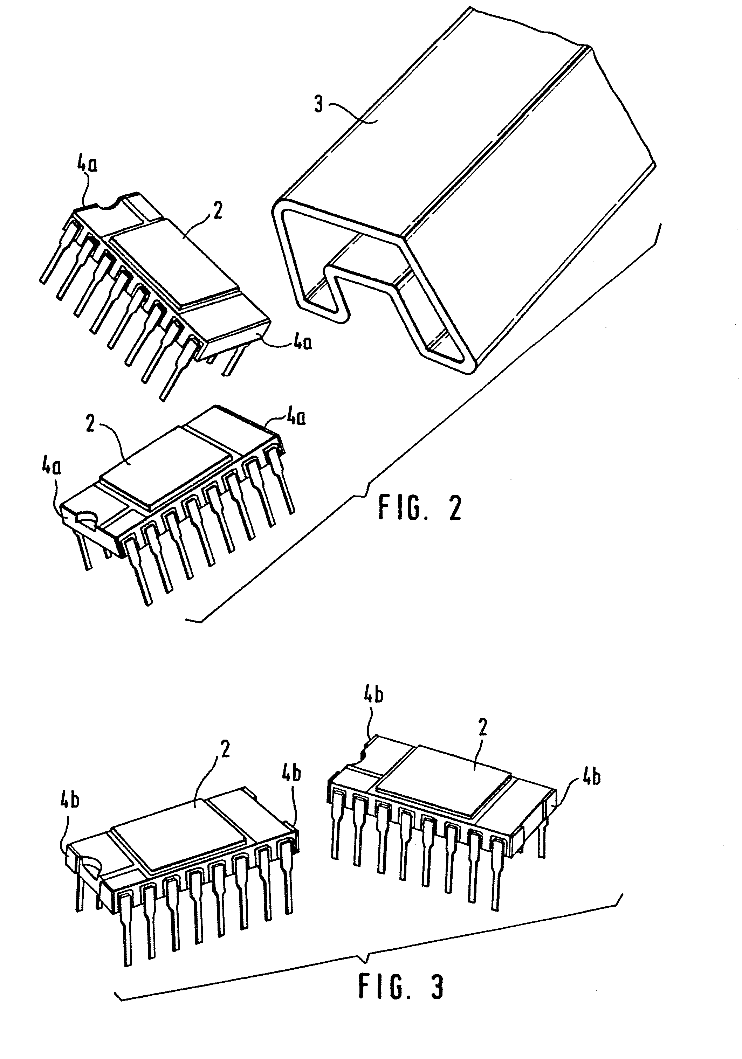

Die Figur 2 zeigt zwei elektrische Bauelemente mit Keramikgehäusen 2, die zum Verschicken in einer Verpackung 3 mit schienenförmigem Querschnitt untergebracht werden.

- 3 -

0199149

Beim Transport der elektrischen Bauelemente läßt sich
nicht vermeiden, daß die Keramikkörper 2 mit ihren Stirnseiten 1 aneinanderstoßen. Dabei besteht die Gefahr, daß
die Keramikkörper 2 beschädigt werden. Um dies zu vermeiden, sind die Stirnseiten 1 der Keramikkörper 2 erfindungsgemäß beschichtet. Die nach der Erfindung vorgesehene Schicht 4a, 4b ist elastisch und so dick bemessen, daß Beschädigungen des Keramikgehäuses 2 vermieden
werden, wenn die Keramikgehäuse 2 beim Transport mit
ihren Stirnseiten 1 aneinanderstoßen. Die Dicke der
Schicht 4a, 4b beträgt beispielsweise 0,1 bis 0,3 mm.
Die Schicht 4a, 4b besteht beispielsweise aus Polyimid,
welches sich aus organischen Verbindungen nach einem
bestimmten Bildungsgesetz zusammensetzt. Daran sind
CH, CO, OH, $H_2N$ Gruppen beteiligt.

Die Figur 3 zeigt eine Ausführungsform der Erfindung,
bei der nicht die gesamten Stirnseiten 1 des Keramikkörpers 2 mit der erfindungsgemäßen Schicht beschichtet sind, sondern nur die Ecken der Stirnseiten mit
der Schicht 4b.

Die Aufbringung der Schichten 4a und 4b erfolgt durch
Aufwalzen oder Auftropfen.

(

Heilbronn, 03.04.1985
T/E7-Se/ra - HN 83/42

Patentansprüche

1) Elektrisches Bauelement mit einem Keramikgehäuse (2), für das eine Verpackungsart vorgesehen ist, bei der mehrere Bauelemente mit ihren Keramikgehäusen stirnseitig aneinandergereiht sind, dadurch gekennzeichnet, daß mindestens eine Stirnseite (1) des Keramikgehäuses (2) mit einer Schicht (4a) ganzflächig oder (4b) teilweise versehen ist, die derart ausgebildet ist, daß sie Transportschäden am Keramikgehäuse, die durch stirnseitiges Aneinanderstoßen beim Transport entstehen können, vermeidet.

2) Elektrisches Bauelement nach Anspruch 1, dadurch gekennzeichnet, daß die Schicht (4a, 4b) elastisch ist.

3) Elektrisches Bauelement nach Anspruch 1 oder 2, dadurch gekennzeichnet, daß die Schicht (4a, 4b) hitzebeständig ist.

4) Elektrisches Bauelement nach einem der vorangehenden Ansprüche, dadurch gekennzeichnet, daß die Schicht (4a, 4b) bis 500 °C hitzebeständig ist.

5) Elektrisches Bauelement nach einem der vorangehenden Ansprüche, dadurch gekennzeichnet, daß die Schicht (4a, 4b) aus Polyimid besteht.

6) Verfahren zur Herstellung eines elektrischen Bauelements nach Anspruch 1, dadurch gekennzeichnet, daß die Schicht (4a, 4b) aufgewalzt oder aufgetropft wird.

FIG. 1

FIG. 2

FIG. 3